# EUROPEAN PATENT SPECIFICATION

(11) **EP 2 642 839 B1**
(45) Date of publication and mention of the grant of the patent: **11.02.2015**
(21) Application number: 12178867.3
(22) Date of filing: 01.08.2012
(51) Int. Cl.: H05K 5/02

(54) **USB memory stick with a hinged safety hook**
USB-Speicherstift mit scharniertem Sicherheitshaken
Clé USB avec un crochet de sécurité à charnière

(30) Priority: 22.03.2012 TW 101205159
(43) Date of publication of application: 25.09.2013
(73) Proprietor: HO E Screw & Hardware Co., Ltd., 33855 Taoyuan (TW)
(72) Inventor: Huang, Joseph, 33955 Taoyuan (TW)
(74) Representative: Ruschke, Hans Edvard

(56) References cited:
- CN-U- 202 014 426
- TW-S- D 135 636
- US-A1- 2008 276 099

## Description

### BACKGROUND OF THE INVENTION

### 1. Field of the Invention:

The present invention relates to memory stick technology and more particularly, to a USB memory stick with a hinged safety hook that is electrically connectable to a computer for data access and facilitates carrying.

### 2. Description of the Related Art:

A USB memory stick is a mobile data storage device convenient for carrying and connectable to a computer for data access. Following development of data storage technology, USB memory stick storage capacity has been greatly expanded for wide field applications, and many USB memory stick circuit board specifications, including USB 2.0, mini USB 2.0 and USB 3.0 have been created. The latest USB 3.0 greatly reduces the size.

Memory sticks are so small that can easily be lost. To prevent loss and to facilitate carrying, a USB memory stick may be equipped with a lock. Similar designs are seen in Taiwan Utility M418377, "Memory stick having a lock device", which is issued to the present inventor; Taiwan Utility D143014, "Buckle type memory stick (I)"; Taiwan Utility D143015, "Buckle type memory stick (II)"; Taiwan Utility D140681, "Memory stick"; Taiwan Utility D135636, "Memory stick".

However, in the aforesaid various prior art designs, the lock device or buckle is fixedly located at the casing and not directionally adjustable to fit different application requirements.

US 2008/276099 A1 shows a Universal Serial Bus (USB) flash drive with locking swivel cap including a USB device, a swivel cap having a top swivel cap face and a bottom swivel cap face, a pivot and a lanyard hole. The swivel cap is connectably attached to the USB device, four locking pins, two of which disposed on the top swivel cap face and two of which disposed on the bottom swivel cap face, two top locking grooves disposed on a top surface of the USB device, and two bottom locking grooves disposed on a bottom surface of the USB device, wherein the locking pins disposed on top swivel cap face coupled with the two top locking grooves and the locking pins disposed on the bottom swivel cap face couple with the two bottom locking grooves allowing the swivel cap to lock in fully open (180 degrees) and fully closed (0 degrees). US 2008/276099 A1 is considered to be the closest prior art as acknowledged in preamble of claim 1.

### SUMMARY OF THE INVENTION

The present invention has been accomplished under the circumstances in view. It is the main object of the present invention to provide a USB memory stick with a hinged safety hook, which facilitates carrying and prevents loss. This and other objects of the present invention are achieved by the features of claim 1.

The invention is defined by the wording of claim 1 featuring a memory stick with a hinged safety hook comprises a casing comprising opposing top and bottom sides and a bottom opening in said bottom side, a PC board comprising a USB interface circuit and a memory chip package, a tray holding the PC board in the casing, a safety hook for fastening to a belt or strip-like object, and a hinge coupled between the casing and the safety hook for allowing a limited angle of rotation between the casing and the safety hook,
wherein the hinge comprises first and second barrels located at the top side of the casing, a third barrel located at the safety hook and inserted in between the first and second barrels, and a pivot shaft connecting the first and second barrels and the third barrel for allowing the third barrel to be turned with the safety hook relative to the casing within a predetermined angle. The pivot shaft comprises an embossed end portion engaged in the second barrel. The second barrel comprises an end block stopping against the embossed end portion of the pivot shaft.

Further, the safety hook comprises a hollow hook head, a curved hook body extended from one end of the hollow hook head, a hook mouth defined between a distal end of the hollow hook head and a distal end of the curved hook body, a coiled spring member mounted inside the hollow hook head, a latch supported on the coiled spring member and forced by the coiled spring member to stop against the distal end of the curved hook body to close the hook mouth, and an operating handle slidably inserted through the coiled spring member in the hook head and fixedly connected with the latch and operable to move the latch away from the distal end of the curved hook body in opening the hook mouth.

Further, the casing comprises a retaining groove disposed in an inside wall thereof. The tray comprises a clip extended from one side thereof and clamped on the memory chip package of the PC board, two spring arms extended from the clip in a parallel manner and pressed on the PC board, and an oblique retaining leaf obliquely extended from the clip between the two spring arms and engaged into the retaining groove of the casing.

Further, the casing is adapted for insertion into a USB port of a computer to electrically connect the USB interface circuit and memory chip package of the PC board to the computer for data access. Further, the hinge enables the safety hook to be turned relative to the casing within a limited angle. Further, by means of the safety hook, the USB memory stick can be fastened to an external object.

In an alternate form of the present invention, the USB memory stick comprises a casing, a PC board, a safety hook and a hinge. According to this second embodiment, the hinge comprises first and second barrels located at the top side of the casing, a third barrel located at the hook head of the safety hook and inserted into the gap between the first and second barrels and defining therein a small inner diameter portion and a large inner diameter portion, and a pivot shaft pivotally connecting the third barrel to the first and second barrels. The pivot shaft comprises a shaft body inserted through the first barrel, the third barrel and the second barrel and fitting the inner diameter of the second barrel and the small inner diameter portion of the third barrel, an expanded head located at one end of the shaft body and fitting the inner diameter of the first barrel and the large inner diameter portion of the third barrel, and a buck-tail located at the opposite end of the shaft body and bucked and secured to the second barrel. Further, a spring member is mounted on the shaft body within the large inner diameter portion of the third barrel and stopped between the expanded head of the pivot shaft and the small inner diameter portion of the third barrel to enhance torque, enabling the safety hook be biased relative to the casing and then positively positioned at the desired position.

Other advantages and features of the present invention will be fully understood by reference to the following specification in conjunction with the accompanying drawings, in which like reference signs denote like components of structure.

### BRIEF DESCRIPTION OF THE DRAWINGS

FIG. 1 is an exploded view of a USB memory stick in accordance with a first embodiment of the present invention.
FIG. 2 is an elevational assembly view of the USB memory stick in accordance with the first embodiment of the present invention.
FIG. 3 is a longitudinal sectional view of the USB memory stick in accordance with the first embodiment of the present invention.
FIG. 4 is a sectional view taken along line A-A of FIG. 3.
FIG. 5 is a schematic drawing illustrating an application example of the USB memory stick in accordance with the first embodiment of the present invention.
FIG. 6 is an exploded view of a USB memory stick in accordance with a second embodiment of the present invention.
FIG. 7 is a side view of the USB memory stick in accordance with the second embodiment of the present invention.
FIG. 8 is a sectional view taken along line A-A of FIG. 7.

### DETAILED DESCRIPTION OF THE PREFERRED EMBODIMENT

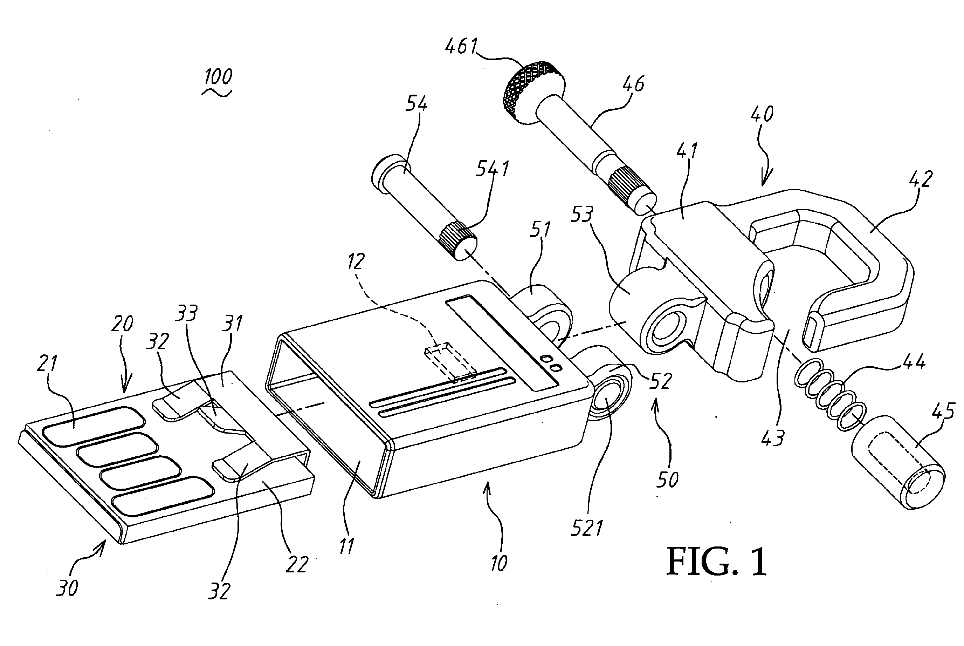

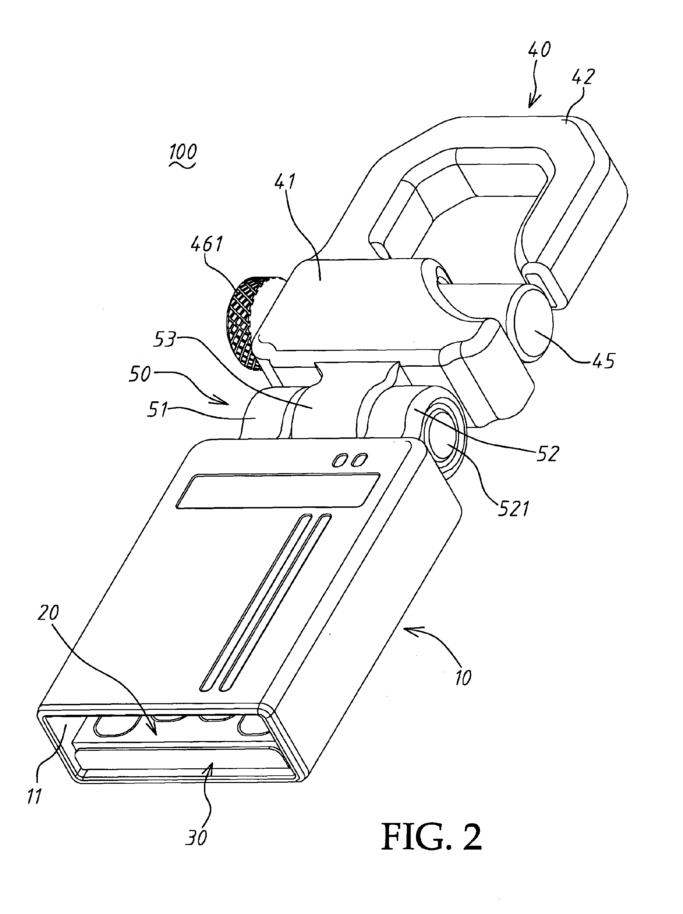

Referring to FIGS. 1 and 2, a USB memory stick in accordance with a first embodiment of the present invention is shown. The USB memory stick **100** comprises a casing **10,** a PC board **20,** a tray **30,** a safety hook **40** and a hinge **50.**

The casing **10** comprises a bottom opening **11** and a retaining groove **12** located on an inside wall thereof.

The PC board **20** comprises a USB interface circuit **21** and a memory chip package **22**. Further, the PC board **20** is supported by the tray **30.** The tray **30** is attached to the whole back side of the PC board **20,** leaving the USB interface circuit **21** exposed to the outside.

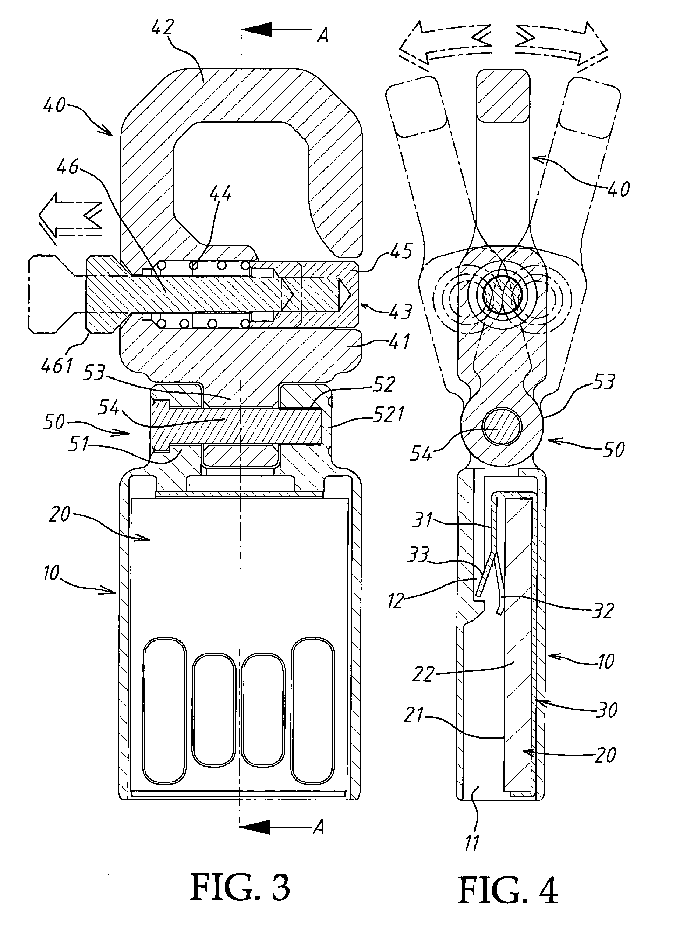

The tray **30** comprises a clip **31** extended from one side thereof and clamped on the memory chip package **22** of the PC board **20,** two spring arms **32** extended from the clip **31** in a parallel manner and pressed on the PC board **20,** and an oblique retaining leaf **33** obliquely extended from the clip **31** between the two spring arms **32,** which is engaged into the retaining groove **12** to secure the tray **30** in position after insertion of the tray **30** with the attached PC board **20** through the bottom opening **11** into the inside of the casing **10,** as shown in FIG. 4. At this time, the USB interface circuit **21** is kept in the bottom opening **11** of the casing **10** accurately.

The safety hook **40** is located at the top side of the casing **10** opposite to the bottom opening **11,** and adapted for fastening to a belt or strip-like object.

The safety hook **40** comprises a hollow hook head **41,** a curved hook body **42** extended from one end of the hollow hook head **41,** a hook mouth **43** defined between a distal end of the hollow hook head **41** and a distal end of the curved hook body **42,** a coiled spring member **44** mounted inside the hollow hook head **41,** a latch **45** supported on the coiled spring member **44** and stopped against the distal end of the curved hook body **42** to close the hook mouth **43,** and an operating handle **46** slidably inserted through the coiled spring member **44** in the hook head **41** and fixedly connected with the latch **45.** The operating handle **46** has an expanded handle head **461** disposed outside the hook head **41.** As illustrated in FIG. 3, a user can pull the handle head **461** of the handle **46** to move the latch **45** away from the distal end of the curved hook body **42,** thereby opening the hook mouth **43.** When the user releases the hand from the handle head **461** of the handle **46,** the latch **45** will be automatically moved back by the coiled spring member **44** into abutment against the distal end of the curved hook body **42,** thereby closing the hook mouth **43.**

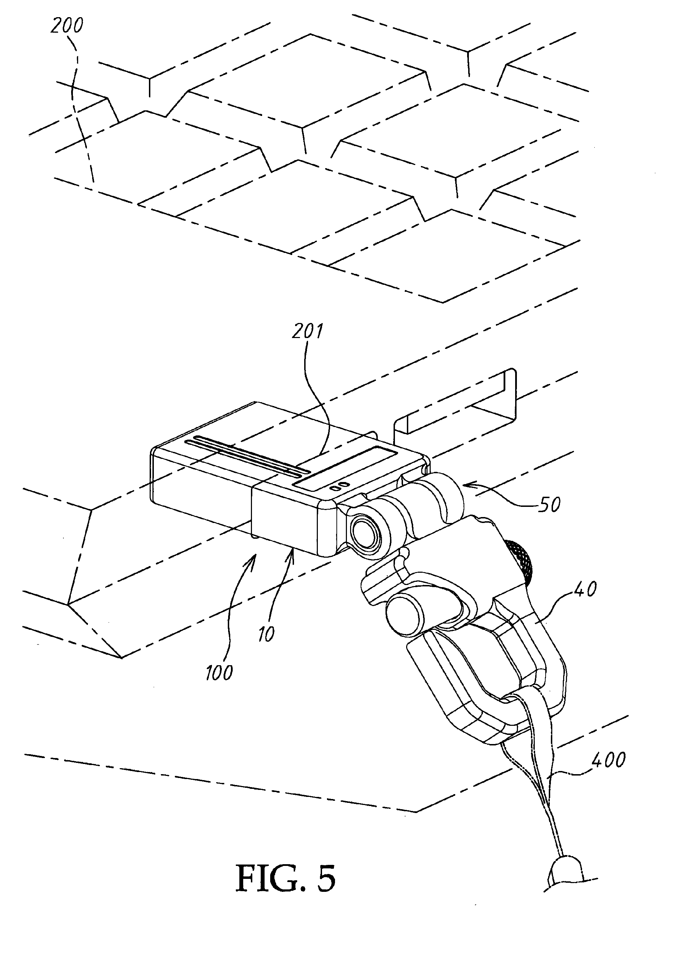

The hinge **50** is coupled between the casing **10** and the safety hook **40,** allowing only a limited angle of rotation between the casing **10** and the safety hook **40,** as illustrated in the imaginary arrowhead signs in FIG. 4 and FIG. 5.

The hinge **50** comprises first and second barrels **51** and **52** located at the top side of the casing **10,** a third barrel **53** located at the hook head **41** of the safety hook **40** and inserted into the gap between the first and second barrels **51** and **52,** and a pivot shaft **54** inserted through the first barrel **51** and the third barrel **53** into the inside of the second barrel **52** and secured thereto. The pivot shaft **54** has an embossed end portion **541** engaged with inside wall of the second barrel **52.** The second barrel **52** has an end block **521** that stops the embossed end portion **541** of the pivot shaft **54** inside the second barrel **52.** Thus, the safety hook **40** can be turned with the third barrel **53** about the pivot shaft **54** relative to the first and second barrels **51** and **52** and the casing **10** within a limited angle.

Referring to FIG. 5, the casing **10** is adapted for insertion into a USB port **201** of a computer **200** to electrically connect the USB interface circuit **21** and memory chip package **22** of the PC board **20** to the computer **200** for data access. Further, the hinge **50** enables the safety hook **40** to be turned relative to the casing **10** within a limited angle. Further, by means of the safety hook **40,** the USB memory stick **100** can be fastened to an external object **400.**

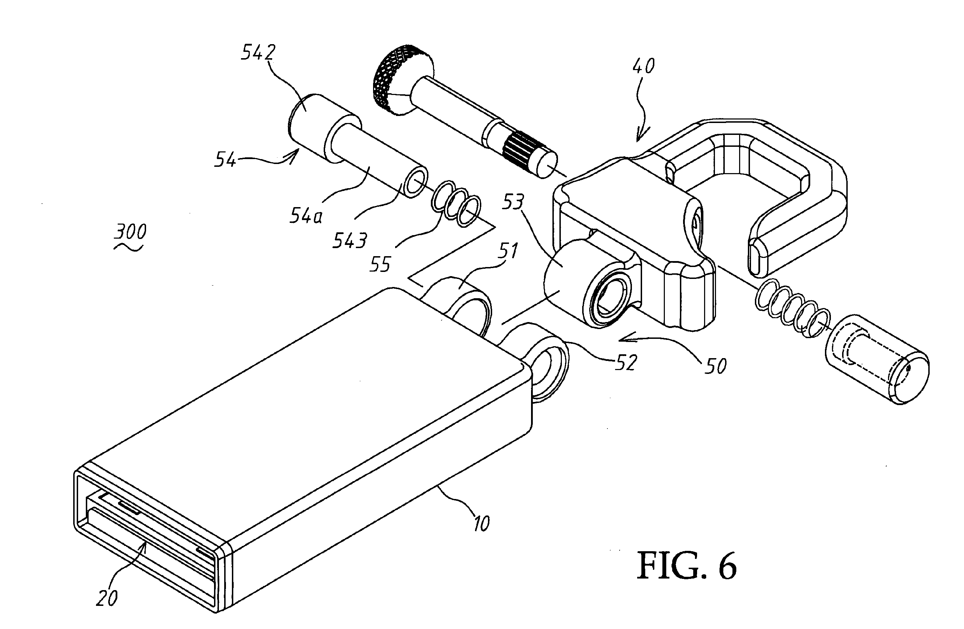

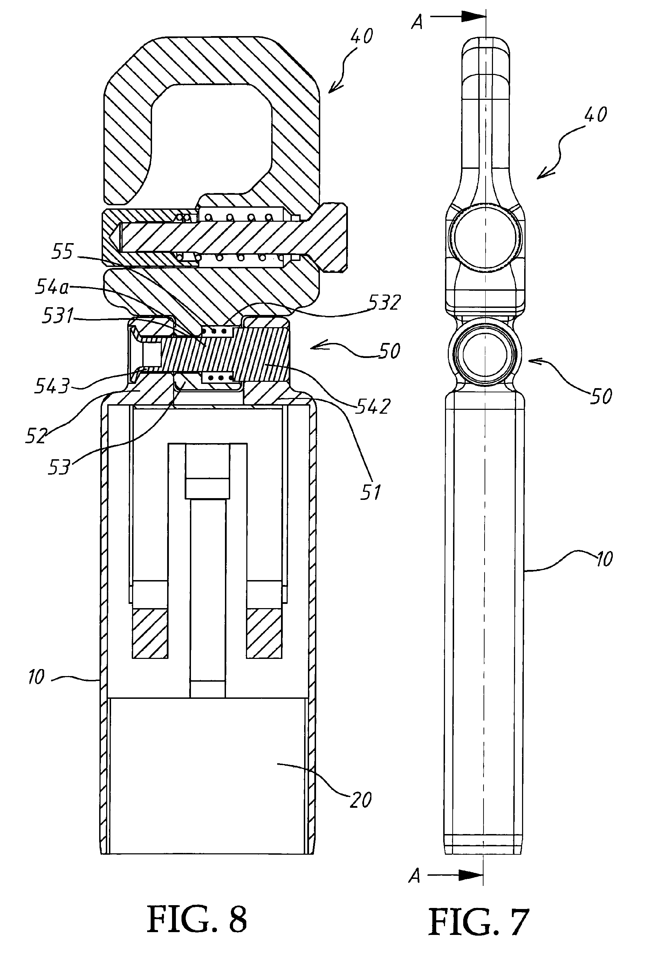

Referring to FIGS. 6-8, a USB memory stick **300** in accordance with a second embodiment of the present invention is shown. The USB memory stick **300** in accordance with the second embodiment of the present invention is substantially similar to the aforesaid first embodiment, comprising a casing **10,** a PC board **20,** a safety hook **40** and a hinge **50.** According to this second embodiment, the hinge **50** comprises first and second barrels **51** and **52** located at the top side of the casing **10,** a third barrel **53** located at the hook head **41** of the safety hook **40** and inserted into the gap between the first and second barrels **51** and **52** and defining therein a small inner diameter portion **531** and a large inner diameter portion **532,** and a pivot shaft **54** pivotally connecting the third barrel **53** to the first and second barrels **51** and **52.** The pivot shaft **54** comprises a shaft body **54a** inserted through the first barrel **51,** the third barrel **53** and the second barrel **52** and fitting the inner diameter of the second barrel **52** and the small inner diameter portion **531** of the third barrel **53,** an expanded head **542** located at one end of the shaft body **54a** and fitting the inner diameter of the first barrel **51** and the large inner diameter portion **532** of the third barrel **53,** and a buck-tail **543** located at the opposite end of the shaft body **54a** and bucked and secured to the second barrel **52.** Further, a spring member **55** is mounted on the shaft body **54a** within the large inner diameter portion **531** of the third barrel **53** and stopped between the expanded head **542** of the pivot shaft **54** and the small inner diameter portion **531** of the third barrel **53** to enhance torque, enabling the safety hook **40** be biased relative to the casing **10** and then positively positioned at the desired position.

Further, the design of the spring member **55** to enhance torque in the aforesaid second embodiment can also be used in the aforesaid first embodiment.

Although particular embodiments of the invention have been described in detail for purposes of illustration, various modifications and enhancements may be made without departing from the scope of the invention. Accordingly, the invention is not to be limited except as by the appended claims.

## Claims

1. A USB memory stick (100, 300), comprising:
a casing (10) comprising opposing top and bottom sides and a bottom opening (11) in said bottom side;
a PC board (20) comprising a USB interface circuit (21) and a memory chip package (22);
a tray (30) holding said PC board (20) in said casing (10);
a safety hook (40) for fastening to a belt or strip-like object; and
a hinge (50) coupled between said casing (10) and said safety hook (40) for allowing a limited angle of rotation between said casing (10) and said safety hook (40);
**characterised in that**
said hinge (50) comprises first and second barrels (51, 52) located at the top side of said casing (10), a third barrel (53) located at said safety hook (40) and inserted in between said first and second barrels (51, 52), and a pivot shaft (54) connecting said first and second barrels (51, 52) and said third barrel (53) for allowing said third barrel (53) to be turned with said safety hook (40) relative to said casing (10) within a predetermined angle.

2. The USB memory stick (100, 300) as claimed in claim 1, wherein said pivot shaft (54) comprises an embossed end portion (541) engaged in said second barrel (52).

3. The USB memory stick (100, 300) as claimed in claim 2, wherein said second barrel (52) comprises an end block (521) stopping against said embossed end portion (541) of said pivot shaft (54).

4. The USB memory stick (100, 300) as claimed in claim 3, wherein said pivot shaft (54) further comprises a shaft body (54a) and an expanded head (542) located at one end of said shaft body (54a); said embossed end portion (541) is located at an opposite end of said shaft body (54a); said first barrel (51) has an inner diameter fitting the expanded head (542) of said pivot shaft (54); said second barrel (52) has an inner diameter fitting said shaft body (54a) and said embossed end portion (541).

5. The USB memory stick (100, 300) as claimed in claim 4, wherein said third barrel (53) defines therein a large inner diameter portion (532) equal to the diameter of said expanded head (542) of said pivot shaft (54) and the inner diameter of said first barrel (51), and a small inner diameter portion (531) equal to the diameter of said shaft body (54a) and said embossed end portion (541) of said pivot shaft (54) and the diameter of said second barrel (52).

6. The USB memory stick (100, 300) as claimed in claim 1, wherein said safety hook (40) comprises a hollow hook head (41), a curved hook body (42) extended from one end of said hollow hook head (41), a hook mouth (43) defined between a distal end of said hollow hook head (41) and a distal end of said curved hook body (42), a coiled spring member (44) mounted inside said hollow hook head (41), a latch (45) supported on said coiled spring member (44) and forced by said coiled spring member (44) to stop against the distal end of said curved hook body (42) to close the hook mouth (43), and an operating handle (46) slidably inserted through said coiled spring member (44) in said hook head (41) and fixedly connected with said latch (45) and operable to move said latch (45) away from the distal end of said curved hook body (42) in opening said hook mouth (43), said operating handle (46) comprising an expanded handle head (461) disposed outside said hook head (41).

7. The USB memory stick (100, 300) as claimed in claim 1, wherein said casing (10) comprises a retaining groove (12) disposed in an inside wall thereof; said tray (30) comprises a clip (31) extended from one side thereof and clamped on said memory chip package (22) of said PC board (20), two spring arms (32) extended from said clip (31) in a parallel manner and pressed on said PC board (20), and an oblique retaining leaf (33) obliquely extended from said clip (31) between said two spring arms (32) and engaged into said retaining groove (12) of said casing (10).

8. The USB memory stick (100, 300) as claimed in claim 1, wherein said pivot shaft (54) comprises a shaft body (54a) inserted through said first barrel (51), said third barrel (53) and said second barrel (52), an expanded head (542) located at one end of said shaft body (54a) and positioned in said first barrel (51), and a buck-tail (543) located at an opposite end of said shaft body (54a) and bucked and secured to said second barrel (52).

9. The USB memory stick (100, 300) as claimed in claim 8, wherein said third barrel (53) defines therein a small inner diameter portion (531) fitting said shaft body (54a) of said pivot shaft (54), and a large inner diameter portion (532) fitting said expanded head (542) of said pivot shaft (54) and accommodating a spring member (55), said spring member (55) being mounted on said shaft body (54a) and stopped between said expanded head (542) of said pivot shaft (54) and said small inner diameter portion (531) of said third barrel (53).

## Patentansprüche

1. USB-Speicherstick (100, 300) mit:
einem Gehäuse (10) mit gegenüber liegenden Ober- und Unterseiten und einer Öffnung (11) in der Unterseite;
einer Leiterplatte (20) mit einer USB-Schnittstellenschaltung (21) und einem Speicher-Chip (22);
einer Schale (30), die die Leiterplatte (20) im Gehäuse (10) haltert;
einem Sicherheitshaken (40), zum Anbringen an einem Gürtel oder streifenartigen Gegenstand; und
einem Scharnier (50) zwischen dem Gehäuse (10) und dem Sicherheitshaken (40), das einen begrenzten Schwenkwinkel zwischen dem Gehäuse (10) und dem Sicherheitshaken (40) zulässt;
**dadurch gekennzeichnet, dass**
das Scharnier (50) einen ersten und einen zweiten Tubus (51, 52) an der Oberseite des Gehäuses(1 0), einen dritten Tubus (53), der am Sicherheitshaken (40) angeordnet und zwischen den ersten und den zweiten Tubus (51, 52) eingefügt ist, und eine Schwenkwelle (54) aufweist, die den ersten und zweiten Tubus (51, 52) mit dem dritten Tubus (53) so verbindet, dass letzterer mit dem Sicherheitshaken (40) relativ zum Gehäuse (10) innerhalb eines vorbestimmten Winkels drehbar ist.

2. USB-Speicherstick (100, 300) nach Anspruch 1, dessen Schwenkwelle (54) einen geprägten Endabschnitt (541) aufweist, der in den zweiten Tubus (52) einsteckbar ist.

3. USB-Speicherstick (100, 300) nach Anspruch 2, dessen zweiter Tubus (52) einen Endblock (521) aufweist, der am geprägten Endabschnitt (541) der Schwenkwelle (54) anliegt.

4. USB-Speicherstick (100, 300) nach Anspruch 3, dessen Schwenkwelle (5) weiterhin einen Schaft (54a) und an einem Ende desselben einen aufgeweiteten Kopf (542) aufweist, wobei der geprägte Endabschnitt (541) sich am anderen Ende des Schafts (54a) befindet und wobei weiterhin der erste Tubus (51) einen zum Kopf (542) der Schwenkwelle (54) und der zweite Tubis (52) einen zum Schaft (54a) der Schwenkwelle und zum geprägten Endabschnitt (541) passenden Innendurchmesser haben.

5. USB-Speicherstick (100, 300) nach Anspruch 4, dessen dritter Tubus (53) einen Abschnitt (532) mit größerem Durchmesser gleich dem des expandierten Kopfes (542) der Schwenkwelle (54) und dem Innendurchmesser des ersten Tubus (51) sowie einen Abschnitt (531) aufweist, dessen kleinerer Innendurchmesser gleich dem Durchmesser des Schafts (54a) und des geprägten Endabschnitts (541) der Schwenkwelle (54) und gleich dem Durchmesser des zweiten Tubs (52) ist.

6. USB-Speicherstick (100, 300) nach Anspruch 1, dessen Sicherungshaken (40) einen hohlen Hakenkopf (41), einen gekrümmten Hakenhauptteil (42), der von einem Ende des hohlen Hakenkopfes (41) abverläuft, und eine Mündung (43) zwischen dem freien Ende des hohlen Hakenkopfes (41) und einem freien Ende des gekrümmten Haken-Hauptteils (42), eine Schraubenfeder (44), die in den hohlen Hakenkopf (41) eingesetzt ist, einen Riegel (45), der auf die Schraubenfeder (44) aufgesetzt ist und von dieser an das distale Ende des gekrümmten Hakenkörpers (42) gedrückt wird, um die Hakenmündung (43) zu schließen, und einen Betätigungsgriff (46) aufweist, der durch die Schraubenfeder (44) in den Hakenkopf (41) einschiebbar, mit dem Riegel (45) fest verbunden und betätigbar ist, um zum Öffnen der Hakenmündung (43) den Riegel (45) vom distalen Ende des gekrümmten Hakenkörpers (42) weg zu bewegen, wobei der Griff (46) einen aufgeweiteten Kopf (461) aufweist, der außerhalb des Hakenkopfes (41) liegt.

7. USB-Speicherstick (100, 300) nach Anspruch 1, dessen Gehäuse (10) innenseitig eine Vertiefung (12) enthält und die Schale (30) eine Spange (31) aufweist, die von einer Seite derselben her absteht und auf das Speicherpaket (22) der Leiterplatte (20) aufgeklemmt ist, wobei zwei Federschenkel (32) parallel von der Spange (31) in paralleler Weise abverlaufen und auf die Leiterplatte (20) aufgedrückt sind, wobei eine Blattfeder (33) zwischen den beiden Federschenkeln (32) schräg vorsteht und in die Vertiefung (12) des Gehäuses (10) einrastet.

8. USB-Speicherstick (100, 300) nach Anspruch 1, dessen Schwenkwelle (54) einen Schaft (54a), der durch den ersten Tubus (51), den dritten Tubus (53) und den zweiten Tubus (52) hindurch eingeschoben ist, im ersten Tubus (51) einen aufgeweiteten Kopf (542) an einem Ende und eine Verformung (543) am anderen Ende des Schafts (54a) aufweist, die im zweiten Tubus (52) aufgeweitet und dort festgelegt ist.

9. USB-Speicherstick (100, 300) nach Anspruch 8, dessen dritter Tubus (53) einen kleinerdurchmessrigen Abschnitt (531), der auf den Schaft (54a) der Schwenkwelle (54) passt, und einen größerdurchmessrigen Abschnitt (532) enthält, der auf den aufgeweiteten Kopf (542) der Schwenkwelle (54) passt und eine Feder (55) aufnimmt, die auf den Schaft (54a) aufgesetzt und zwischen den Kopf (542) der Schwenkwelle (54) und den kleinerdurchmessrigen Abschnitt (531) des dritten Tubus (53) eingespannt ist.

## Revendications

1. Clé USB (100, 300), comprenant :
un boîtier (10) comprenant des côtés supérieur et inférieur opposés et une ouverture inférieure (11) dans ledit côté inférieur ;
une carte à circuit imprimé (20) comprenant un circuit d'interface USB (21) et un boîtier de puce de mémoire (22) ;
un support (30) maintenant ladite carte à circuit imprimé (20) dans ledit boîtier (10) ;
un crochet de sécurité (40) pour une fixation à une ceinture ou un objet analogue à une bande ; et
une charnière (50) couplée entre ledit boîtier (10) et ledit crochet de sécurité (40) pour permettre un angle de rotation limité entre ledit boîtier (10) et ledit crochet de sécurité (40) ;
**caractérisée en ce que**
ladite charnière (50) comprend des premier et deuxième barillets (51, 52) positionnés au côté supérieur dudit boîtier (10), un troisième barillet (53) positionné audit crochet de sécurité (40) et inséré à l'intérieur entre lesdits premier et deuxième barillets (51, 52), et un axe de pivot (54) reliant lesdits premier et deuxième barillets (51, 52) et ledit troisième barillet (53) pour permettre audit troisième barillet (53) d'être tourné avec ledit crochet de sécurité (40) par rapport audit boîtier (10) selon un angle prédéterminé.

2. Clé USB (100, 300) selon la revendication 1, dans laquelle ledit axe de pivot (54) comprend une portion d'extrémité estampée (541) engagée dans ledit deuxième barillet (52).

3. Clé USB (100, 300) selon la revendication 2, dans laquelle ledit deuxième barillet (52) comprend un bloc d'extrémité (521) s'arrêtant contre ladite portion d'extrémité estampée (541) dudit axe de pivot (54).

4. Clé USB (100, 300) selon la revendication 3, dans laquelle ledit axe de pivot (54) comprend en outre un corps d'axe (54a) et une tête élargie (542) positionnée en une extrémité du corps d'axe (54a) ; ladite portion d'extrémité estampée (541) est positionnée en une extrémité opposée dudit corps d'axe (54a) ; ledit premier barillet (51) a un diamètre intérieur adapté à la tête élargie (542) dudit axe de pivot (54) ; ledit deuxième barillet (52) a un diamètre intérieur adapté audit corps d'axe (54a) et à ladite portion d'extrémité estampée (541).

5. Clé USB (100, 300) selon la revendication 4, dans laquelle ledit troisième barillet (54) définit dans celui-ci une portion à grand diamètre intérieur (532) égale au diamètre de ladite tête élargie (542) dudit axe de pivot (54) et au diamètre intérieur dudit premier barillet (51), et une portion à petit diamètre intérieur (531) égale au diamètre dudit corps d'axe (54a) et de ladite portion d'extrémité estampée (541) dudit axe de pivot (54) et au diamètre dudit deuxième barillet (52).

6. Clé USB (100, 300) selon la revendication 1, dans laquelle ledit crochet de sécurité (40) comprend une tête de crochet creuse (41), un corps de crochet incurvé (42) s'étendant à partir d'une extrémité de ladite tête de crochet creuse (41), un bec de crochet (43) défini entre une extrémité distale de ladite tête de crochet creuse (41) et une extrémité distale dudit corps de crochet incurvé (42), un organe à ressort enroulé (44) monté à l'intérieur de ladite tête de crochet creuse (41), un loquet (45) supporté sur ledit organe à ressort enroulé (44) et forcé par ledit organe à ressort enroulé (44) pour s'arrêter contre l'extrémité distale dudit corps de crochet incurvé (42) pour fermer le bec de crochet (43), et une manette d'actionnement (46) insérée de manière coulissante à travers ledit organe à ressort enroulé (44) dans ladite tête de crochet (41) et fixement reliée audit loquet (45) et apte à fonctionner pour écarter ledit loquet (45) de l'extrémité distale dudit corps de crochet incurvé (42) en ouvrant ledit bec de crochet (43), ladite mannette d'actionnement (46) comprenant une tête de poignée élargie (461) disposée à l'extérieur de ladite tête de crochet (41).

7. Clé USB (100, 300) selon la revendication 1, dans laquelle ledit boîtier (10) comprend une rainure de retenue (12) disposée dans une paroi intérieure de celle-ci ; ledit support (30) comprend une pince (31) s'étendant à partir d'un côté de celui-ci et serrée sur ledit boîtier de puce de mémoire (22) de ladite carte à circuit imprimé (20), deux bras à ressort (32) s'étendant à partir de ladite pince (31) de manière parallèle et pressés sur ladite carte à circuit imprimé (20), et une lame de retenue oblique (33) s'étendant de manière oblique à partir de ladite pince (31) entre lesdits deux bras à ressort (32) et engagée dans ladite rainure de retenue (12) dudit boîtier (10).

8. Clé USB (100, 300) selon la revendication 1, dans laquelle ledit axe de pivot (54) comprend un corps d'axe (54a) inséré à travers ledit premier barillet (51), ledit troisième barillet (53) et ledit deuxième barillet (52), une tête élargie (542) positionnée à une extrémité dudit corps d'axe (54a) et positionnée dans ledit premier barillet (51), et une queue de rivet (543) positionnée à une extrémité opposée dudit corps d'axe (54a) et rivetée et fixée audit deuxième barillet (52).

9. Clé USB (100, 300) selon la revendication 8, dans laquelle ledit troisième barillet (53) définit dans celui-ci une portion à petit diamètre intérieur (531) adaptée audit corps d'axe (54a) dudit axe de pivot (54), et une portion à grand diamètre intérieur (532) adaptée à ladite tête élargie (542) dudit axe de pivot (54) et recevant un organe à ressort (55), ledit organe à ressort (55) étant monté sur ledit corps d'axe (54a) et arrêté entre ladite tête élargie (542) dudit axe de pivot (54) et ladite portion à petit diamètre intérieur (531) dudit troisième barillet (53).
